(19) Europäisches Patentamt
European Patent Office
Office européen des brevets

(11) **EP 2 927 951 B1**

(12) **EUROPEAN PATENT SPECIFICATION**

(45) Date of publication and mention
of the grant of the patent:
**24.03.2021 Bulletin 2021/12**

(51) Int Cl.:
**H01L 23/29** (2006.01)      **C09D 133/06** (2006.01)
**H01L 23/31** (2006.01)      **C09D 133/14** (2006.01)

(21) Application number: **13858565.8**

(86) International application number:
**PCT/JP2013/066888**

(22) Date of filing: **19.06.2013**

(87) International publication number:
**WO 2014/083874 (05.06.2014 Gazette 2014/23)**

(54) **COMPOSITION FOR A PROTECTIVE FILM, PROTECTIVE FILM FORMED FROM THE COMPOSITION, AND CHIP WITH CURED PROTECTIVE FILM**

ZUSAMMENSETZUNG FÜR EINEN SCHUTZFILM, AUS DER ZUSAMMENSETZUNG HERGESTELLTER SCHUTZFILM UND CHIP MIT AUSGEHÄRTETEM SCHUTZFILM

COMPOSITION POUR UN FILM DE PROTECTION, FILM DE PROTECTION FORMÉ À PARTIR DE LA COMPOSITION, ET PUCE AVEC FILM DE PROTECTION DURCI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.11.2012 JP 2012262493**

(43) Date of publication of application:
**07.10.2015 Bulletin 2015/41**

(73) Proprietor: **LINTEC Corporation**
**Tokyo 173-0001 (JP)**

(72) Inventors:
• **YAMAMOTO, Daisuke**
**Itabashi-ku, Tokyo 173-0001 (JP)**
• **AZUMA, Yuichiro**
**Itabashi-ku, Tokyo 173-0001 (JP)**

(74) Representative: **Gille Hrabal**
**Partnerschaftsgesellschaft mbB**
**Patentanwälte**
**Brucknerstraße 20**
**40593 Düsseldorf (DE)**

(56) References cited:
WO-A1-2009/138990      JP-A- H0 516 296
JP-A- H02 150 415       JP-A- 2002 030 223
JP-A- 2008 006 386      JP-A- 2010 135 621
US-A1- 2001 021 740     US-A1- 2007 026 572
US-A1- 2007 142 528     US-A1- 2008 260 982

• **KIRAN M S R N ET AL: "Improved mechanical properties of polymer nanocomposites incorporating graphene-like BN: Dependence on the number of BN layers", SCRIPTA MATERIALIA, ELSEVIER, AMSTERDAM, NL, vol. 64, no. 6, 1 March 2011 (2011-03-01), pages 592-595, XP027590534, ISSN: 1359-6462 [retrieved on 2011-01-10]**
• **C. Y. ZHI ET AL: "Mechanical and Thermal Properties of Polymethyl Methacrylate-BN Nanotube Composites", JOURNAL OF NANOMATERIALS, vol. 2008, 1 January 2008 (2008-01-01), pages 1-5, XP055280323, US ISSN: 1687-4110, DOI: 10.2320/matertrans.47.1882**
• **C. ZHI, Y. BANDO, C. TANG, H. KUWAHARA, D. GOLBERG: "Large-Scale Fabrication of Boron Nitride Nanosheets and Their Utilization in Polymeric Composites with Improved Thermal and Mechanical Properties", ADVANCED MATERIALS, vol. 21, 2009, pages 2889-2893, XP002758822, Weinheim**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

The present invention relates to: a composition for forming a protective film provided for protecting a face on the opposite side of a circuit face of a chip such as, for example, a semiconductor chip; a protective sheet comprising a protective film made of the composition; and a chip with a cured protective film or sheet on a surface thereof.

Background Art

In recent years, production of semiconductor apparatuses using a mounting method that is so called face down system has been conducted. In the face down system, a semiconductor chip (hereinafter, also simply referred to as "chip") comprising an electrode such as a bump on a circuit face is used, and the electrode is joined with a substrate. Therefore, there sometimes occurs the case that the surface on the opposite side of the circuit face of the chip (the back surface of the chip) is exposed.

And there sometimes occurs the case that the exposed back surface of the chip is protected by a protective film made of an organic film and incorporated in the semiconductor apparatus as a chip with a protective film. Generally, the chip with the protective film can be obtained by coating a back surface of a wafer with a liquid resin by a spin coating method, then drying and curing the liquid resin to form a protective film on the wafer, and cutting the wafer.

However, the thickness precision of the protective film thus formed is insufficient, and therefore there has been a problem that lowering of the product yield may occur.

In order to solve the problem, a protective film-forming sheet for a chip, the sheet comprising a protective film-forming layer that is formed on a release face of a release sheet and comprises: at least one of a heat-curable component and an energy ray-curable component; and a binder polymer component is disclosed in Patent Literature 1, for example Patent Literature 1 discloses a composition for forming a protective film in accordance with the first part of claim 1.

Patent Literature 2 discloses the use of scale-shaped BN filler and a grain-shaped other filler of alumina, silica etc. in order to improve the thermal performance of a thermosetting resin for an electronic component

Patent Literature 3 discloses a protective film-forming composition for forming a protective film for protecting a surface of a chip, whereby the composition comprises an acrylic polymer, a curable component and an inorganic filler, wherein the content of the constitutional unit derived from a glycidyl group-containing monomer relative to all the structural units constituting the acrylic polymer is 0 to 8 % by mass, and the glass transition temperature of the acrylic polymer used in the example section (HTR-860P-3) is -7 °C.

Citation List

Patent Literature

PTL 1: Japanese Patent Laid-Open No. 2002-280329 (family member US2008/260982 A1)
PTL 2: JP H05 16296 A
PTL3: US 2007/026572 A

Summary of Invention

Technical Problem

By the way, heat generation from a semiconductor apparatus has been problematic as the density of the semiconductor apparatus incorporating a semiconductor chip increases and the speed of production process of the semiconductor apparatus increases in recent years. It sometimes occurs the case that the heat generation from the semiconductor apparatus causes the semiconductor apparatus to deform resulting in a cause of breakdown or damage, or brings about lowering of the operation speed or malfunction of the semiconductor apparatus, resulting in degradation of the reliability of the semiconductor apparatus. Therefore, effective heat dissipation performance has been required for the semiconductor chip to be incorporated in a high-performance semiconductor apparatus.

Moreover, a favorable adhesion performance with an adherend to be a material for forming a circuit such as copper foil or a resist is also required for a protective film applied to the semiconductor chip.

Furthermore, in the case where the semiconductor chip with a protective film is incorporated into the semiconductor apparatus, lifting, delamination, or cracks occur at a joint of the semiconductor chip and the protective film attributable to temperature changes of the semiconductor chip caused by the repetition of heat generation and cooling, and degradation of the reliability of the chip with the protective film becomes problematic.

The present invention intends to provide: a protective film-forming composition that is capable of forming a cured protective film having excellent heat dissipation performance and adhesion performance and that is capable of producing a highly reliable chip with a cured protective film; a protective film-forming sheet comprising a protective film made of the composition; and a chip with a cured protective film.

Solution to Problem

The present inventors have found that the problems can be solved by setting the content of a constitutional unit derived from a glycidyl group-containing monomer in the protective film-forming composition to be a material for forming the cured protective film to a particular range, the protective film-forming composition comprising: an acrylic copolymer having a predetermined glass transition temperature; a curable component; and an inorganic filler comprising a particular boron nitride particle, and have completed the present invention.

That is to say, the present invention provides the following composition in accordance with claim 1:

[1] A composition for forming a protective film for protecting a surface of a chip, the composition comprising: an acrylic polymer (A); a curable component (B); and an inorganic filler (C), wherein
a content of a constitutional unit derived from a glycidyl group-containing monomer relative to all the structural units constituting the acrylic polymer (A) is 0 to 8% by mass, and the acrylic polymer (A) has a glass transition temperature of -3°C or higher;
characterized in that:

the acrylic polymer (A) comprises a constitutional unit (a1) derived from a (meth)acrylic acid alkyl ester and a constitutional unit (a2) derived from a monomer comprising a functional group other than the glycidyl group and a content of the constitutional unit (a1) derived from the (meth)acrylic acid alkyl ester comprising an alkyl group having 4 or more carbon atoms relative to all the structural units constituting the acrylic polymer (A) is 0 to 12% by mass; and

the inorganic filler (C) comprises anisotropically shaped boron nitride particles (C1) having an aspect ratio 2 to 30 (C1) and a further inorganic filler (C2) other than the anisotropically shaped boron nitride particles.

In a preferred embodiment the content of the boron nitride particles relative to the total amount of effective components contained in the composition is 3 to 40% by mass, wherein effective components are components of the composition excluding solvents of the components contained in the composition.

In another preferred embodiment an average particle diameter of the boron nitride particles (C1) is 10 to 30 $\mu$m and wherein the value of the average particle diameter is calculated as an arithmetic mean value of the major axis diameters measured for 20 particles randomly selected in a transmission electron micrograph photograph.

In another preferred embodiment the further inorganic filler (C2) is a spherical inorganic filler having an average particle diameter of 10 to 40 $\mu$m.

In another preferred embodiment the anisotropically shaped boron nitride particles (C1) have at least one shape selected from the group consisting of a plate shape, an acicular shape, and a scale-like shape, and wherein a mass ratio of the further inorganic filler (C2) to the boron nitride particles (C1) is 1/2 to 7/1.

In another preferred embodiment the composition further comprises a colorant (D).

In another preferred embodiment the composition further comprises a coupling agent (E).

In another preferred embodiment the composition has content of the acrylic polymer (A) of 5 to 50% by mass, a content of the curable component (B) of 5 to 50% by mass, and a content of the inorganic filler (C) of 20 to 90% by mass relative to the total amount of effective components contained in the composition, wherein effective components are components of the composition excluding solvents of the components contained in the composition.

In accordance with a further preferred embodiment of the invention, a protective sheet in accordance with claim 9 is provided.

In accordance with another preferred embodiment of the invention the protective film of claim 9 is cured and has a thermal conductivity of 1.0 W/(m·K) or more.

In accordance with another preferred embodiment of the invention the protective film has a thickness of 10 to 70 $\mu$m.

In accordance with another preferred embodiment of the invention a chip is provided with a cured protective film on a surface of a chip, the cured protective film obtained by curing a protective film made of the composition according to any one of claims 1 to 8 a cured protective sheet according to any one of claims 9 to 11.

Advantageous Effects of Invention

The cured protective film obtained by curing the composition of the present invention has excellent heat dissipation performance and adhesion performance. Moreover, the chip with the cured protective film of the present invention has an excellent reliability.

Description of Embodiments

In the description below, each of the "weight average molecular weight (Mw)" and the "number average molecular weight (Mn)" is a value in terms of polystyrene measured by a gel permeation chromatography (GPC) method, and is specifically a value measured based on the method described in Examples.
Moreover, for example, the "(meth)acrylate" is used as a term that represents both the "acrylate" and the "methacrylate", and the same applies to other similar terms.

[Protective Film-Forming Composition]

The protective film-forming composition (hereinafter, also simply referred to as "the composition of the present invention") is a composition according to claim 1 for forming a protective film for protecting the surface of a chip, the composition comprising: an acrylic polymer (A); a curable component (B); and an inorganic filler (C).
Moreover, it is preferable that the protective film-forming composition of the present invention further comprises a colorant (D) and a coupling agent (E), and may comprise another additive such as a cross-linking agent as necessary.
In addition, the "effective components" contained in the protective film-forming composition denotes, in the present invention, components excluding solvents from the components contained in the composition, and specifically means the above-described components (A) to (E) and the another additive added as necessary, such as a cross-linking agent.
Hereinafter, each component contained in the protective film-forming composition of the present invention will be described.

<Acrylic Polymer (A)>

The acrylic polymer (A) contained in the protective film-forming composition of the present invention is a component that imparts flexibility and film formation performance to the protective film formed from the composition of the present invention.
In the present invention, the content of the constitutional unit derived from a glycidyl group-containing monomer relative to all the constitutional units constituting the acrylic polymer (A) is 0 to 8% by mass. When the content of the constitutional unit derived from the glycidyl group-containing monomer exceeds 8% by mass, the compatibility of the component (B) with a cured product is improved and a phase-separated structure becomes hardly formed. As a result thereof, in the case where the chip with the cured protective film comprising the cured protective film formed using the obtained protective film-forming composition is produced, lifting, delamination, or cracks attributable to temperature changes are become liable to occur at a joint of the cured protective film and the chip to degrade the reliability of the chip with the cured protective film. Moreover, there is a tendency that the adhesion of the cured protective film to be formed is lowered.
The content of the constitutional unit derived from a glycidyl group-containing monomer relative to all the constitutional units constituting the acrylic polymer (A) is 0 to 8% by mass, preferably 0 to 6% by mass, more preferably 0 to 5% by mass, further preferably 0 to 3% by mass, even further preferably 0 to 0.5% by mass from the standpoint of improving the reliability of the chip with the cured protective film to be obtained and also from the standpoint of improving the adhesion of the cured protective film to be formed.
In addition, examples of the glycidyl group-containing monomer include glycidyl (meth)acrylate, methyl glycidyl (meth)acrylate, and allyl glycidyl ether.
Moreover, the glass transition temperature (Tg) of the component (A) is - 3°C or higher in the present invention.
When the Tg of the component (A) is lower than -3°C, the mobility of the component (A) is not suppressed, the deformation of the cured protective film attributable to temperature changes occurs, and lifting, delamination, or cracks become liable to occur at the joint of the cured protective film and the chip to degrade the reliability of the chip with the cured protective film in the case where the chip with the cured protective film comprising a cured protective film formed using the protective film-forming composition. Furthermore, there is a tendency that the thermal conductivity of the cured protective film to be formed is lowered and the heat dissipation performance is deteriorated.
In other words, by setting the glass transition temperature (Tg) of the component (A) to -3°C or higher, the reliability of the chip with the cured protective film can be improved, and the heat dissipation performance of the cured protective film formed from the composition of the present invention can also be improved.

The glass transition temperature (Tg) of the component (A) is -3°C or higher, preferably -1°C or higher, more preferably 1°C or higher, further preferably 3°C or higher, even further preferably 5°C or higher from the standpoint of improving the reliability of the chip with the cured protective film to be formed and also improving the heat dissipation performance of the cured protective film to be formed from the composition of the present invention.

Moreover, the upper limit value of the glass transition temperature (Tg) of the component (A) is not particularly limited, however the glass transition temperature (Tg) of the component (A) is preferably 100°C or lower, more preferably 50°C or lower.

In addition, in the case where the component (A) consists of a plurality of acrylic polymers, a value obtained by taking a weighted average of the glass transition temperatures of respective acrylic polymers is defined as the glass transition temperature of the component (A).

Moreover, in the present invention, the glass transition temperature (Tg) of the component (A) is a value obtained by converting the glass transition temperature ($Tg_K$) expressed by the absolute temperature (unit; K) and calculated by the following formula (1) to Celsius degree (unit; °C).

$$\frac{100}{Tg_K} = \frac{W_1}{Tg_1} + \frac{W_2}{Tg_2} + \frac{W_3}{Tg_3} + \frac{W_4}{Tg_4} + \cdots \qquad (1)$$

[In the formula (1), $W_1$, $W_2$, $W_3$, $W_4$, and ... each represent a mass fraction (mass%) of each monomer component constituting the acrylic polymer, and $Tg_1$, $Tg_2$, $Tg_3$, $Tg_4$, and ... each represent a glass transition temperature expressed by the absolute temperature (K) of a homopolymer of each component of the acrylic polymer.]

The acrylic polymer (A) contained in the composition of the present invention includes polymers containing a (meth)acrylic acid alkyl ester as a main component, and copolymers comprising a constitutional unit (a1) derived from a (meth)acrylic acid alkyl ester and a constitutional unit (a2) derived from a monomer comprising a functional group other than a glycidyl group are preferably.

In addition, the component (A) may be used alone or in combination of two or more.

The number of carbon atoms of the alkyl group in the (meth)acrylic acid alkyl ester that constitutes the constitutional unit (a1) is preferably 1 to 18, more preferably 1 to 8 from the standpoint of imparting the flexibility and the film formation performance to the protective film to be formed, and further preferably 1 to 3 from the standpoint of further adjusting the Tg of the acrylic polymer and improving the reliability of the chip with the cured protective film using the composition of the present invention.

Examples of the specific (meth)acrylic acid alkyl ester include methyl (meth)acrylate, ethyl (meth)acrylate, propyl (meth)acrylate, butyl (meth)acrylate, pentyl (meth)acrylate, 2-ethylhexyl (meth)acrylate, isooctyl (meth)acrylate, n-octyl (meth)acrylate, n-nonyl (meth)acrylate, isononyl (meth)acrylate, decyl (meth)acrylate, lauryl (meth)acrylate, and stearyl (meth)acrylate.

Among them, (meth)acrylic acid alkyl esters comprising an alkyl group having 1 to 3 carbon atoms are preferable, and methyl (meth)acrylate is more preferable from the standpoint of adjusting the Tg of the acrylic polymer.

Here, the content of the constitutional unit derived from the (meth)acrylic acid alkyl ester comprising an alkyl group having 4 or more carbon atoms relative to all the structural units constituting the acrylic polymer (A) is 0 to 12% by mass, more preferably 0 to 10% by mass, further preferably 0 to 7% by mass, even further preferably 0 to 3% by mass from the standpoint of adjusting the Tg of the acrylic polymer and improving the reliability of the chip with the cured protective film using the composition of the present invention and improving the heat dissipation performance of the cured protective film to be formed.

When the content is 12% by mass or less, the Tg of the acrylic polymer does not become excessively low and it becomes easy to adjust the Tg of the acrylic polymer so as to be equal to or higher than the predetermined value, and therefore the reliability of the chip with the cured protective film using the composition of the present invention can be improved and the heat dissipation performance of the cured protective film formed from the composition of the present invention can also be improved.

The content of the constitutional unit (a1) relative to all the structural units constituting the acrylic polymer (A) is preferably 50% by mass or more, more preferably 60 to 99% by mass, further preferably 65 to 95% by mass, even further preferably 70 to 90% by mass.

Moreover, the content of the constitutional unit derived from methyl (meth)acrylate in the constitutional unit (a1) is preferably 70 to 100% by mass, more preferably 80 to 100% by mass, further preferably 90 to 100% by mass, even further preferably 97 to 100% by mass from the standpoint of adjusting the Tg of the acrylic polymer and improving the reliability of the chip with the cured protective film using the composition of the present invention and also improving the heat dissipation performance of the cured protective film to be formed.

Examples of the monomer comprising a functional group other than the glycidyl group and constituting the constitutional unit (a2) include carboxyl group-containing monomers, hydroxy group-containing monomers, amide group-containing monomers, amino group-containing monomers, cyano group-containing monomers, keto group-containing monomers, monomers comprising a nitrogen atom-containing ring, and alkoxysilyl group-containing monomers. Among them, hydroxy group-containing monomers are preferable.

In addition, the functional group-containing monomers may be used alone or in combination of two or more.

Examples of the hydroxy group-containing monomer include: hydroxyalkyl (meth)acrylates such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, and 4-hydroxybutyl (meth)acrylate; and unsaturated alcohols such as vinyl alcohol, and allyl alcohol.

Among them, 2-hydroxyethyl (meth)acrylate is preferable.

The content of the constitutional unit (a2) relative to all the structural units constituting the acrylic polymer (A) is preferably 1 to 42% by mass, more preferably 5 to 30% by mass, further preferably 8 to 25% by mass, even further preferably 10 to 20% by mass.

In addition, the acrylic polymer (A) used in the present invention may comprise a constitutional unit derived from another monomer (however, excluding a glycidyl group-containing monomer) other than the above-described constitutional units (a1) and (a2) within a range that does not impair the effects of the present invention.

The weight average molecular weight (Mw) of the acrylic polymer (A) is preferably 10000 to 2000000, more preferably 50000 to 1200000, further preferably 100000 to 800000, even further preferably 200000 to 600000 from the standpoint of imparting the flexibility and the film formation performance to the protective film to be formed.

The content of the component (A) relative to the total amount of effective components contained in the protective film-forming composition of the present invention is preferably 5 to 50% by mass, more preferably 8 to 40% by mass, further preferably 10 to 30% by mass, even further preferably 12 to 25% by mass.

<Curable Component (B)>

The curable component (B) contained in the protective film-forming composition of the present invention is a component for forming a cured protective film by curing a protective film made of the composition of the present invention.

As the curable component (B), for example, a heat-curable component, a heat curing agent, and a curing accelerator, or an energy ray-polymerizable compound and a photopolymerization initiator can be used, and the curable components may be used in combination thereof.

(Heat-Curable Component)

As the heat-curable component, epoxy compounds are preferable from the standpoint of obtaining a composition having an excellent curability.

As the epoxy compound, known epoxy compounds can be used, and examples thereof include epoxy compounds comprising two or more functional groups within the molecule such as biphenyl compounds, diglycidyl ether of bisphenol A and a hydrogenated product thereof, ortho cresol novolak epoxy resins, dicyclopentadiene type epoxy resins, biphenyl type epoxy resins, bisphenol A type epoxy resins, bisphenol F type epoxy resins, phenylene skeleton type epoxy resins, and phenoxy resins.

Among them, bisphenol A type epoxy resins and dicyclopentadiene type epoxy resins are preferable.

In addition, these heat-curable components may be used alone or in combination of two or more.

(Heat Curing Agent)

The heat curing agent functions as a curing agent for the heat-curable component such as the above-described epoxy resins.

As the heat curing agent, compounds comprising two or more functional groups reactable with the epoxy group within one molecule are preferable.

Examples of the functional group include phenolic hydroxy groups, alcoholic hydroxy groups, amino groups, a carboxy group, acid anhydrides. The phenolic hydroxy groups, the amino groups, and the acid anhydrides are preferable, and phenolic hydroxy groups and the amino groups are more preferable.

Examples of phenolic curing agent comprising a phenolic hydroxy group include polyfunctional phenolic resins, biphenol, novolak type phenolic resins, dicyclopentadiene phenolic resins, xyloc type phenolic resins, and aralkyl phenolic resins.

Examples of amine curing agents comprising an amino group include dicyandiamide.

These heat curing agents may be used alone or in combination of two or more.

The content of the heat curing agent relative to 100 mass parts of the heat-curable components is preferably 0.1 to 100 mass parts, more preferably 0.5 to 50 mass parts, further preferably 1 to 20 mass parts, even further preferably 1.5 to 10 mass parts from the standpoint of adhesion performance of the cured protective film formed from the composition of the present invention and of suppressing the hygroscopic property of the cured protective film.

(Curing Accelerator)

The curing accelerator is used for adjusting the curing rate of the protective film, and is preferably used together with the heat-curable component and the heat curing agent.

Examples of the curing accelerator include: tertiary amines such as triethylenediamine, benzyldimethylamine, triethanolamine, dimethylaminoethanol, and tris(dimethylaminomethyl) phenol; imidazoles such as 2-methyl imidazole, 2-phenyl imidazole, 2-phenyl-4-methyl imidazole, 2-phenyl-4,5-dihydroxymethyl imidazole, and 2-phenyl-4-methyl-5-hydroxymethyl imidazole; organophosphines such as tributylphosphine, diphenylphosphine, and triphenylphosphine; and tetraphenylboron salts such as tetraphenylphosphonium tetraphenylborate and triphenylphosphine tetraphenylborate.

These curing accelerators may be used alone or in combination of two or more.

The content of the curing accelerator relative to 100 mass parts of the heat-curable components is preferably 0.01 to 20 mass parts, more preferably 0.1 to 15 mass parts, further preferably 0.5 to 10 mass parts, even further preferably 1 to 5 mass parts from the standpoint of the adhesion performance of the cured protective film formed from the composition of the present invention and the reliability of the semiconductor chip with the cured protective film.

(Energy Ray-Polymerizable Compound)

The energy ray-polymerizable compound is a compound comprising an energy ray-polymerizable group and being polymerized and cured by polymerization when irradiated with an energy ray such as an ultraviolet ray or an electron beam.

Specific examples of the energy ray-polymerizable compound include trimethylolpropane tri(meth)acrylate, pentaerythritol (meth)acrylate, pentaerythritol tetra(meth)acrylate, dipentaerythritol monohydroxy penta(meth)acrylate, dipentaerythritol hexa(meth)acrylate, 1,4-butylene glycol di(meth)acrylate, 1,6-hexanediol di(meth)acrylate, polyethylene glycol di(meth)acrylate, oligoester (meth)acrylates, urethane (meth)acrylate oligomers, polyether (meth)acrylates, and itaconic acid oligomers.

In addition, these energy ray-polymerizable compounds may be used alone or in combination of two or more.

Moreover, the weight average molecular weight of the energy ray-polymerizable compound is preferably 100 to 30000, more preferably 300 to 10000.

Moreover, in the case where the composition comprises the energy ray-polymerizable compound as the curable component (B), it is preferable to further blend a photopolymerization initiator from the standpoint of accelerating curing.

Examples of the photopolymerization initiator include benzophenone, acetophenone, benzoin, benzoin methyl ether, benzoin ethyl ether, benzoin isopropyl ether, benzoin isobutyl ether, benzoin benzoic acid, benzoin methyl benzoate, benzoin dimethyl ketal, 2,4-diethyl thioxanthone, $\alpha$-hydroxy cyclohexyl phenyl ketone, benzyl diphenyl sulfide, tetramethylthiuram monosulfide, azobisisobutyronitrile, benzil, dibenzil, diacetyl, 1,2-diphenylmethane, 2-hydroxy-2-methyl-1-[4-(1-methylvinyl)phenyl]propanone, 2,4,6-trimethylbenzoil diphenylphosphine oxide, and $\beta$-chloroanthraquinone.

These photopolymerization initiator may be used alone or in combination of two or more.

The content of the photopolymerization initiator relative to 100 mass parts of the energy ray-polymerizable compound is preferably 0.1 to 10 mass parts, more preferably 1 to 5 mass parts from the standpoint of accelerating curing.

The content of the component (B) relative to the total amount of effective components contained in the protective film-forming composition of the present invention is preferably 5 to 50% by mass, more preferably 8 to 40% by mass, further preferably 10 to 30% by mass, even further preferably 12 to 25% by mass.

In addition, the aforementioned heat curing agent, curing accelerator, and photopolymerization initiator are included in the component (B) in the present invention, the blending amount of the heat curing agent and the curing accelerator is included in the content of the component (B) in the case where the heat-curable component is used as the component (B), and the blending amount of the photopolymerization initiator is also included in the content of the component (B) in the case where the energy ray-polymerizable compound is used as the component (B).

<Inorganic Filler (C)>

The protective film-forming composition of the present invention comprises an inorganic filler (C) comprising anisotropically shaped boron nitride particle (particles) (C1).

The thermal conductivity of the cured protective film to be formed can be improved by the protective film-forming composition comprising the inorganic filler (C), and it becomes possible to further improve the thermal conductivity of the cured protective film and to effectively dissipate the generated heat from the semiconductor apparatus in which a semiconductor chip with a cured protective film is mounted by the protective film-forming composition comprising the anisotropically shaped boron nitride particle (C1) as the component (C).

In addition, a cured protective film formed from a composition not comprising the component (C1) has a favorable adhesion with an adherend such as a copper foil or resist, but is inferior in heat dissipation performance because the heat conductivity is lowered. Moreover, in the case where the chip with the cured protective film comprising a cured protective film formed using the composition to be obtained is produced, the deformation of the cured protective film attributable to temperature changes occurs, and lifting, delamination, or cracks become liable to occur at the joint of the protective film and the chip, and therefore there is a tendency that the reliability of the chip with the cured protective film is degraded.

Moreover, the protective film-forming composition of the present invention comprises, as the inorganic filler (C), an inorganic filler (C2) other than the anisotropically shaped boron nitride particle from the standpoint of improving the thermal conductivity of the cured protective film to be formed and improving the adhesion performance of the cured protective film.

The inorganic filler other than the anisotropically shaped boron nitride particle that is the component (C1) exists as the component (C2) in the cured protective film to be formed, thereby allowing the component (C 1) to exist so that the component (C1) is leaned on the component (C2), as a result thereof, the thermal conductivity in the thickness direction of the cured protective film is further improved, and the adhesion performance of the cured protective film is also improved.

The content of the component (C) relative to the total amount of effective components contained in the protective film-forming composition of the present invention is preferably 20 to 90% by mass, more preferably 30 to 80% by mass, further preferably 40 to 75% by mass, even further preferably 50 to 70% by mass.

(Anisotropically Shaped Boron Nitride Particle (C1))

The anisotropically shaped boron nitride particle as the component (C1) has anisotropy, and it is preferable that the boron nitride has, as the specific shape, at least one shape selected from the group consisting of a plate shape, an acicular shape, and a scale-like shape.

In addition, the "anisotropic shape" in the present invention means a shape having an aspect ratio [(number average major axis diameter)/(number average minor axis diameter)] of the particle of 2 or more.

The aspect ratio [(number average major axis diameter)/(number average minor axis diameter)] of the component (C1) is 2 to 30, preferably 5 to 25, further preferably 8 to 20, even further preferably 10 to 15 from the standpoint of improving the thermal conductivity of the protective film to be formed.

In addition, each value of the number average major axis diameter and the number average minor axis diameter for calculating the aspect ratio of the component (C) in the present invention is a number average particle diameter that is calculated as each arithmetic mean value of the major axis diameters and the minor axis diameters measured for 20 particles randomly selected in a transmission electron microscope photograph.

The average particle diameter of the component (C1) is preferably 3 to 30 $\mu$m, more preferably 5 to 25 $\mu$m, further preferably 8 to 20 $\mu$m, even further preferably 10 to 16 $\mu$m.

In addition, the value of the average particle diameter of the component (C) in the present invention is a number average particle diameter that is calculated as an arithmetic mean value of the major axis diameters measured for 20 particles randomly selected in a transmission electron micrograph photograph.

The particle diameter distribution (CV value) of the component (C1) is preferably 5 to 40%, more preferably 10 to 30% from the standpoint of imparting a uniform thermal conductivity to the cured protective film to be formed.

In addition, the value of the particle diameter distribution (CV value) of the component (C) in the present invention is a value determined by conducting electron microscope observation to measure the major axis diameters for 200 particles, then determining the standard deviation of the major axis diameters, and calculating (standard deviation of the major axis diameters)/(average particle diameter) using the above-mentioned average particle diameter.

The thermal conductivity in the major axis direction of the component (C1) is preferably 60 to 400 W/(m·K), more preferably 100 to 300 W/(m·K).

Moreover, the density of the component (C1) is preferably 1.5 to 5.0 g/cm$^3$, more preferably 2.0 to 4.0 g/cm$^3$, further preferably 2.2 to 3.0 g/cm$^3$.

The content of the component (C1) relative to the total amount of effective components contained in the protective film-forming composition of the present invention is preferably 3 to 40% by mass, more preferably 5 to 35% by mass, further preferably 10 to 30% by mass, even further preferably 16 to 25% by mass. When the content of the component (C1) is 3% by mass or more, the thermal conductivity of the cured protective film to be formed can further be improved, and the cured protective film having an excellent heat dissipation performance can be formed. On the other hand, when the content of the component (C1) is 40% by mass or less, the adhesion performance of the cured protective film becomes favorable.

(Inorganic Filler (C2) Other Than Anisotropically Shaped Boron Nitride Particle)

As the inorganic filler other than the anisotropically shaped boron nitride particle, the inorganic filler being the component (C2), a spherical inorganic filler is preferable from the standpoint of improving the thermal conductivity of the cured protective film to be formed and improving the adhesion performance of the cured protective film.

Moreover, examples of the inorganic filler as the component (C2) include a silica particle, an alumina particle, a zinc oxide particle, a magnesium oxide particle, a titanium particle, a silicon carbide particle, a spherical (aspect ratio of less than 2) boron nitride particle that is not an anisotropically shaped boron nitride, single crystal fiber, and glass fiber. Among them, the silica particle or the alumina particle is preferable, and the alumina particle is more preferable.

It is preferable from the standpoint of improving the thermal conductivity of the cured protective film to be formed and the film formation performance of the composition, and improving the filling rate of the component (C1) in the cured protective film that the average particle diameter of the component (C2) is smaller than the average particle diameter of the component (C1).

Specific average particle diameter of the component (C2) is preferably 10 to 40µm, more preferably 12 to 35 µm, further preferably 15 to 30 µm, even further preferably 17 to 25 µm from the above-described standpoint.

The particle diameter distribution (CV value) of the component (C2) is preferably 5 to 40%, more preferably 10 to 30% from the standpoint of improving the thermal conductivity of the cured protective film to be formed and improving the adhesion performance of the cured protective film.

The mass ratio [(C2)/(C1)] of the component (C2) to the component (C1) is preferably 1/2 to 7/1, more preferably 1/1 to 6/1, more preferably 1.2/1 to 5/1, further preferably 1.5/1 to 4/1, even further preferably 1.7/1 to 3/1.

When the mass ratio is 1/2 or more, the thermal conductivity of the cured protective film to be formed can be improved, and the adhesion performance of the cured protective film can also be improved.

On the other hand, when the mass ratio is 7/1, the thickening of the composition of the present invention to be obtained can be suppressed, and a flat protective film can be formed.

The content of the component (C2) relative to the total amount of effective components contained in the protective film-forming composition of the present invention is preferably 10 to 50% by mass, more preferably 20 to 49% by mass, further preferably 25 to 46% by mass, even further preferably 30 to 44% by mass.

<Colorant (D)>

It is preferable that the protective film-forming composition of the present invention further comprises a colorant (D).

When a semiconductor chip comprising a cured protective film formed from the composition is incorporated in an instrument, infrared rays or the like generated from a nearby apparatus are blocked and the malfunction of the semiconductor chip can be prevented by the protective film-forming composition comprising a colorant (D). Moreover, for example, when a product number or mark is printed on the cured protective film that is formed by a laser marking method or the like, the contrast between the printed part and the unprinted part becomes large, and therefore the discrimination of the printed character can be improved.

As the colorant (D), organic or inorganic pigments, and dyes can be used.

Examples of the dye include acid dyes, reactive dyes, direct dyes, disperse dyes, and cationic dyes, and any of these dyes can be used.

Moreover, the pigment is not particularly limited, and any pigment can be used by an appropriate selection from among known pigments.

Among these colorants, black pigments are preferable from the standpoint of a favorable shielding performance against electromagnetic waves or infrared rays and further improvements in the discrimination of the cured protective film to be formed by a laser marking method.

Examples of the black pigment include carbon black, ferrous oxides, manganese dioxide, aniline black, and active carbon. The carbon black is preferable from the standpoint of enhancing the reliability of the semiconductor chip with the cured protective film.

In addition, these colorants (D) may be used alone or in combination of two or more.

The average particle diameter of the colorant (D) is preferably 1 to 200 nm, more preferably 5 to 100 nm, further preferably 10 to 50 nm.

The content of the component (D) relative to the total amount of effective components contained in the protective film-forming composition of the present invention is preferably 0.1 to 30% by mass, more preferably 0.5 to 25% by mass, further preferably 1.0 to 15% by mass, even further preferably 1.2 to 5% by mass.

<Coupling Agent (E)>

It is preferable that the protective film-forming composition of the present invention further comprises a coupling agent (E). The polymer component and the surface of the semiconductor chip or the filler which is an adherend can be bonded in the cured protective film to be formed and the adhesion performance or the cohesion performance can be improved by the protective film-forming composition comprising a coupling agent (E). Moreover, the water resistance can be improved without impairing the thermal resistance of the cured protective film to be formed.

As the coupling agent (E), compounds reacting with a functional group contained in the component (A) or the component (B) are preferable, and silane coupling agents are more preferable. Examples of the silane coupling agent include γ-glycidoxypropyl trimethoxy silane, γ-glycidoxypropyl methyl diethoxy silane, β-(3,4-epoxycyclohexyl) ethyl trimethoxy silane, γ-(methacryloxypropyl) trimethoxy silane, γ-aminopropyl trimethoxy silane, N-6-(aminoethyl)-γ-aminopropyl trimethoxy silane, N-6-(aminoethyl)-γ-aminopropyl methyl diethoxy silane, N-phenyl-y-aminopropyl trimethoxy silane, γ-ureido propyl triethoxy silane, γ-mercaptopropyl trimethoxy silane, γ-mercaptopropyl methyl dimethoxy silane, bis(3-triethoxysilylpropyl) tetrasulfane, methyl trimethoxy silane, methyl triethoxy silane, vinyl trimethoxy silane, vinyltriacetoxy silane, and imidazole silane.

These coupling agents (E) may be used alone or in combination of two or more.

As the coupling agent (E), oligomer type coupling agents are preferable.

The number average molecular weight (Mn) of the coupling agent (E) including the oligomer type coupling agent is preferably 100 to 15000, more preferably 150 to 10000, further preferably 200 to 5000, even further preferably 350 to 2000.

The content of the component (E) relative to the total amount of effective components contained in the protective film forming composition of the present invention is preferably 0.1 to 20% by mass, more preferably 0.15 to 10% by mass, further preferably 0.2 to 5% by mass, even further preferably 0.25 to 2% by mass.

<Another Additive>

The protective film-forming composition of the present invention may comprise another additive such as a cross-linking agent, a leveling agent, a plasticizer, an anti-static agent, an anti-oxidant, an ion-capturing agent, a gettering agent, and a chain-transfer agent as necessary within a range that does not impair the effects of the present invention.

The content of these additives is appropriately adjusted as necessary in a range that does not impair the effects of the present invention, but is preferably 10% by mass or less, more preferably 5% by mass or less, further preferably 3% by mass or less relative to the total amount of effective components contained in the protective film-forming composition of the present invention.

The cross-linking agent is blended in order to adjust the initial adhesion and cohesion of the cured protective film to be formed, and examples thereof include organic polyvalent isocyanate compounds, and organic polyvalent imine compounds.

[Protective Film-Forming sheet]

The protective film-forming sheet of the present invention is not particularly limited as long as the protective film-forming sheet comprises a protective film made of the aforementioned protective film-forming composition.

The constitution of the protective film-forming sheet of the present invention may be a single layer sheet consisting of only a protective film, a multilayer sheet in which the protective film is formed on a support sheet or a release sheet, or a multilayer sheet in which the protective film is held between two release sheets or between a release sheet and a support sheet, or the protective film-forming sheet of the present invention may be a pressure sensitive adhesion sheet comprising a pressure sensitive adhesive layer on a face of s support sheet and/or a protective film.

The pressure sensitive adhesive constituting the pressure sensitive adhesive layer includes rubber-based pressure sensitive adhesives, acrylic pressure sensitive adhesives, silicone-based pressure sensitive adhesives, polyvinyl ether-based pressure sensitive adhesives, energy ray-curable type pressure sensitive adhesives that are cured by the irradiation with an energy ray to be having removability, heat-foaming type pressure sensitive adhesives, and water-swelling type pressure sensitive adhesives.

Among them, energy ray-curable pressure sensitive adhesives are preferable.

The thickness of the pressure sensitive adhesive layer can appropriately be adjusted, but is preferably 5 to 200 μm, more preferably 7 to 150 μm, further preferably 10 to 100 μm.

Examples of the support sheet used in the protective film-forming sheet include film such as polyethylene film, polypropylene film, polybutene film, polybutadiene film, polymethyl pentene film, polyvinyl chloride film, vinyl chloride copolymer film, polyethylene terephthalate film, polyethylene naphthalate film, polybutylene terephthalate film, polyurethane film, ethylene/vinyl acetate copolymer film, ionomer resin film, ethylene/(meth)acrylic acid copolymer film, ethylene/(meth)acrylic acid ester copolymer film, polystyrene film, polycarbonate film, polyimide film, and fluororesin film. Moreover, a crosslinked film of these polymers may be used, and a laminated film obtained by laminating 2 or more of these films may be used.

In addition, colored film may be used as the support sheet.

The release sheet used in the protective film-forming sheet includes a sheet in which release treatment is applied on the above-mentioned support sheet.

Examples of the release agent used for the release treatment include alkyd-based, silicone-based, fluorine-based, unsaturated polyester-based, polyolefin-based, and wax-based release agents, and alkyd-based, silicone-based, and fluorine-based release agents are preferable from the standpoint of heat resistance.

The thickness of the support sheet and the release sheet is preferably 10 to 500 $\mu$m, more preferably 15 to 300 $\mu$m, further preferably 20 to 200 $\mu$m.

The thickness of the protective film is preferably 10 to 70 $\mu$m, more preferably 15 to 50 $\mu$m, further preferably 20 to 45 $\mu$m.

The thermal conductivity of the cured protective film obtained by curing the protective film is preferably 1.0 W/(m·K) or more, more preferably 2.0 W/(m·K) or more, further preferably 2.2 W/(m·K) or more, even further preferably 2.5 W/(m·K) or more.

In addition, the thermal conductivity of the cured protective film means a value measured by the method described in Examples.

[Method for Producing Protective Film-Forming Sheet]

The method for producing a protective film-forming sheet of the present invention is not particularly limited, and the protective film-forming sheet of the present invention can be produced by a known method. For example, the protective film-forming sheet of the present invention can be produced by adding an organic solvent to the above-mentioned protective film-forming composition to make a solution form of the protective film-forming composition, coating the support sheet or release sheet with the solution by a known coating method to form a coated film, and thereafter drying the coated film to form a protective film.

The organic solvent to be used includes toluene, ethyl acetate, and methyl ethyl ketone.

The solid concentration of the solution of the protective film-forming composition in the case where the organic solvent is blended is preferably 10 to 80% by mass, more preferably 20 to 70% by mass, further preferably 30 to 65% by mass.

Examples of the coating method include a spin coating method, a spray coating method, a bar coating method, a knife coating method, a roll coating method, a roll knife coating method, a blade coating method, die coating method, and gravure coating method.

[Chip with Cured Protective Film]

The protective film-forming composition or the protective film-forming sheet of the present invention can be used as a protective film-forming material protecting the back surface of the semiconductor chip.

The chip with the cured protective film of the present invention comprises a protective film made of the protective film-forming composition of the present invention or a cured protective film obtained by curing the protective film of the above-mentioned protective film-forming sheet on the surface of a chip such as a semiconductor chip.

In addition, the cured protective film is preferably a cured protective film that is completely cured.

The chip with the cured protective film of the present invention comprises a cured protective film which is obtained by curing the protective film made of the composition of the present invention and which has a high thermal conductivity, and therefore has an excellent heat dissipation performance, and the chip with the cured protective film of the present invention can suppress the occurrence of lifting, delamination, or cracks at the joint of the chip and the protective film attributable to temperature changes, and therefore has an excellent reliability.

A semiconductor apparatus can be produced by mounting the chip with the cured protective film on a substrate or the like by a face-down system. Moreover, a semiconductor apparatus can also be produced by adhering the chip with the cured protective film on a die pad section or another member (on chip-mounted section) such as another semiconductor chip.

[Method for Producing Chip with Cured Protective Film]

The method for producing a chip with a cured protective film of the present invention is not particularly limited, and examples thereof include the following method.

First of all, the protective film of the protective film-forming sheet of the present invention is laminated on the back surface of a semiconductor wafer. Thereafter, in the case where the protective film-forming sheet comprises a support sheet or a release sheet, the support sheet or the release sheet is removed, and the protective film laminated on the semiconductor wafer is subjected to heat-curing and/or photo-curing to form a cured protective film in which the protective film is cured on the whole surface of the wafer. In addition, it is preferable that the cured protective film to be formed is completely cured.

In addition, the semiconductor wafer may be a silicon wafer, or may be a wafer of a compound semiconductor such as gallium arsenide. Moreover, the semiconductor wafer is what is specified as a semiconductor wafer in which a circuit is formed on the surface thereof, grinding or the like is appropriately performed on the back surface thereof, and the thickness is about 50 to about 500 $\mu$m.

Next, the laminated body of the semiconductor wafer and the cured protective film is diced for every circuit formed on the surface of the wafer.

Dicing is conducted so as to cut both the wafer and the cured protective film, and the laminated body of the semiconductor wafer and the cured protective film is divided into a plurality of chips by dicing. In addition, dicing of the wafer is conducted by a usual method using a dicing sheet. Next, the diced chip is picked up by general means such as collet to obtain a semiconductor chip comprising a cured protective film on the back surface thereof (chip with a cured protective film).

In addition, the method for producing a semiconductor chip is not limited to the above example, and, for example, the removal of the support sheet or the release sheet may be conducted after heat-curing and/or photo-curing of the protective film, or may be conducted after dicing.

In addition, in the case where the removal of the support sheet or the release sheet is conducted after dicing, the support sheet or the release sheet can function as a dicing sheet.

Moreover, the chip with the cured protective film may be produced in such a way that dicing is conducted before curing the protective film to make a chip with an uncured protective film, and thereafter the protective film of the chip is subjected to heat-curing and/or photo curing.

Examples

The weight average molecular weight (Mw) and the number average molecular weight (Mn) of the components used in the following Examples and Comparative Examples are the values measured by the method shown below, and the glass transition temperature of acrylic polymers is the value calculated by the method shown below.

<Weight Average Molecular Weight (Mw) and Number Average Molecular Weight (Mn)>

The weight average molecular weight (Mw) and the number average molecular weight (Mn) were measured using a gel permeation chromatograph apparatus (manufactured by Tosoh Corporation, product name "HLC-8220GPC") under the following conditions, and the measured values in terms of polystyrene were used.

(Measurement Conditions)

- Column: "TSK guard column HXL-H", "TSK gel GMHXL ($\times$ 2), and "TSK gel G2000HXL) (all manufactured by Tosoh Corporation)
- Column temperature: 40°C
- Eluent: tetrahydrofuran
- Flow rate: 1.0 mL/min

<Glass Transition Temperature (Tg)>

The glass transition temperature (Tg) was calculated in degrees centigrade (°C) for every composition ratio of respective monomer components using the above-mentioned formula (1). The glass transition temperatures of a homopolymer of each monomer component used for the calculation are as follows.

- Butyl acrylate (BA): -54°C
- Methyl acrylate (MA): 10°C
- 2-Hydroxyethyl acrylate (2HEA): -15°C
- Glycidyl methacrylate (GMA): 41°C

Each component used in Examples and Comparative Examples is as follows.

<Component (A): Acrylic Polymer>

Acrylic polymers denoted as (A-1) to (A-5) shown in Table 1 were used.

Table 1

| | Acrylic polymer (A) | | | | | |
|---|---|---|---|---|---|---|
| | Monomer component*1 (mass%) | | | | Tg (°C) | Mw |
| | BA | MA | 2HEA | GMA | | |
| A-1 | 0 | 85 | 15 | 0 | 6 | 400000 |
| A-2 | 1 | 79 | 15 | 5 | 7 | 370000 |
| A-3 | 55 | 10 | 15 | 20 | -28 | 800000 |
| A-4 | 1 | 74 | 15 | 10 | 8 | 440000 |
| A-5 | 15 | 65 | 15 | 5 | -4 | 340000 |
| *1: Abbreviations for the monomer components are as follows<br>BA = butyl acrylate, MA = methyl acrylate,<br>2HEA = 2-hydroxyethyl acrylate, and GMA = glycidyl methacrylate | | | | | | |

<Component (B): Curable Component>

(Epoxy Compound)

- "BPA328": trade name, manufactured by Nippon Shokubai Co., Ltd., liquid bisphenol A type epoxy resin.
- "EPIKOTE 1055": trade name, manufactured by Mitsubishi Chemical Corporation, solid bisphenol A type epoxy resin.
- "HP7200HH": trade name, manufactured by DIC Corporation, dicyclopentadiene type epoxy resin.

(Heat Curing Agent)

• "DICY": trade name, manufactured by Mitsubishi Chemical Corporation, dicyandiamide.

(Curing Accelerator)

- "2PH-Z": manufactured by Shikoku Chemicals Corporation, 2-phenyl-4,5-dihydroxy imidazole.

<Component (C1): Plate-Shaped Boron Nitride Particle >

- "UHP-2": trade name, manufactured by Showa Denko K.K., plate-shaped boron nitride particle, average particle diameter 11.8 $\mu$m, aspect ratio 11.2, thermal conductivity in the major axis direction 200 W/(m·K), density 2.3 g/cm$^3$.

<Component (C2): Inorganic Filler Other Than The Anisotropically Shaped Boron Nitride Particle>

- "PT-620": trade name, manufactured by Momentive Performance Materials Inc., granular boron nitride particle, average particle diameter 16 to 30 $\mu$m.
- "CB-20A": trade name, manufactured by Showa Denko K.K., spherical alumina particle, average particle diameter 20 $\mu$m.

<Component (D): Colorant>

- "MA-600B": trade name, manufactured by Mitsubishi Chemical Corporation, carbon black, average particle diameter 20 nm.

<Component (E): Silane Coupling Agent>

- "X-41-1056": trade name, manufactured by Shin-Etsu Chemical Co., Ltd., oligomer type silane coupling agent, methoxy equivalent amount 17.1 mmol/g, number average molecular weight (Mn) 500 to 1500.

Moreover, the physical properties of the cured protective films that were formed were measured and evaluated using protective film-forming sheets and semiconductor chips with a protective film manufactured in the following Examples and Comparative Examples by the methods below.

(1) Measurement Method of Thermal Conductivity

One of the release sheets of the manufactured protective film-forming sheet was removed, then the protective film of the protective film-forming sheet was placed under an environment at 130°C for 2 hours to be completely cured, thereafter the other release sheet was removed, and the thermal diffusivity of the cured protective film alone was measured with a thermal diffusivity/thermal conductivity measurement apparatus (manufactured by ai-Phase Co., Ltd., product name "ai-Phase Mobile 1u") to calculate the thermal conductivity of the cured protective film by the following calculation formula (2). In addition, the specific heat of the cured protective sheet alone was calculated by the DSC method, and the density was calculated by the Archimedes method.

$$\text{Calculation formula (2): thermal conductivity } (W/(m \cdot K)) = \text{thermal diffusivity} \times \text{density} \times \text{specific heat}$$

(2) Measurement Method of Peeling Strength of Copper Foil

One of the release sheets of manufactured protective film-forming sheet was removed, and the polished surface (thickness: 350 $\mu$m) of a semiconductor wafer whose back surface was polished to #2000 was laminated (lamination rate: 0.3 m/min) on the exposed protective film while heating at 70°C. Thereafter, the other release sheet of the protective film-forming sheet was removed, and a copper foil (alloy designation "C 1220R" conformed to JIS H3100) which was cut in a strip shape (5 cm $\times$ 10 mm $\times$ 150 $\mu$m) was laminated (lamination rate: 0.3 m/min) on the exposed protective film while heating at 70°C. And the laminated product was left standing in an environment at 130°C for 2hours, and the protective film was completely heat-cured to form a cured protective film.
Thereafter, the peeling strength (unit: N/10 mm) at the time when the strip-shaped copper foil was peeled from the cured protective film at a peeling rate of 50 mm/min while the peeling angle is kept at 90° was measured using a precision universal tester (manufactured by Shimadzu Corporation, trade name "Autograph AG-1S").

(3) Method of Evaluating Reliability

In a thermal shock apparatus (manufactured by ESPEC CORP., product name "TSE-11A"), 25 manufactured semiconductor chips with a cured protective film were set, and a cycle of "holding the temperature at -40°C for 10 minutes, and thereafter holding the temperature at 125°C for 10 minutes" was repeated 100 times.
Thereafter, the cross section of each semiconductor chip with a cured protective film was observed with a scanning ultrasonic test equipment (manufactured by Hitachi Kenki Fine Tech Co., Ltd., product name "Hye-Focus") to check whether lifting, delamination, or cracks occurred or not at a joint of the semiconductor chip and the cured protective film for semiconductor chips with a cured protective film taken out from the thermal shock apparatus. The semiconductor chips in which lifting, delamination, or cracks were observed were determined to be NG. The number of semiconductor chips determined to be NG among 25 semiconductor chips is shown in Table 2. The reliability is more excellent as the number is smaller.

Examples 1 to 3 and Comparative Examples 1 to 6

(1) Preparation of Protective Film-Forming Composition

The protective film-forming compositions were prepared by blending each of the above-described components in a blending amount shown in Table 2. In addition, the blending amount of each component shown in Table 2 is the mass ratio (effective component ratio) when the total amount of the protective film-forming composition is 100 mass parts.
And a methyl ethyl ketone solution was added to each of the prepared protective film-forming compositions so that the solid concentration became 61% by mass to obtain each solution of the protective film-forming compositions.

(2) Manufacture of Protective Film-Forming Sheet

The release-treated face of a release sheet (manufactured by Lintec Corporation, trade name "SP-PET381031", thickness 38 $\mu$m) to which release treatment was applied with silicone was coated with the solution of the above-described protective film-forming composition by means of a roll type coating machine so that the thickness after drying became 40 $\mu$m to form a coated film.
Next, drying treatment was applied to the coated film that was formed at 110°C for 2 minutes to form a protective film having a thickness of 40 $\mu$m, and then a release sheet that was separately prepared and was the same kind of the above-described release sheet was stuck to the exposed face of the protected film to manufacture a protective film-forming sheet.

(3) Production of Semiconductor Chip with Protective Film

One of the release sheets of the above-described protective film-forming sheet that was manufactured was removed, and the exposed protective film was stuck to the polished face of a silicon wafer (diameter: 200 mm, thickness: 280 $\mu$m) polished to #2000 with a tape mounter (manufactured by Lintec Corporation, product name "Adwill RAD-3600 F/12") while heating at 70°C to obtain a silicon wafer with a protective film.
And the other release sheet of the silicon wafer with a protective film was removed, and the protective film was placed under an environment at 130°C for 2 hours to be completely cured, thereby forming a cured protective film. Thereafter, a dicing tape (manufactured by Lintec Corporation, trade name "Adwill D-676H) was bonded to the exposed side of the cured protective film, and dicing into a 3 mm × 3 mm size was conducted with a dicing apparatus (manufactured by DISCO Corporation, product name "DFD651") to obtain a semiconductor chip with a protective film.
The results of measuring and evaluating the physical properties of the protective film-forming sheets and semiconductor chips with a cured protective film obtained in the manner as described above are shown in Table 2.

Table 2

| | Protective film-forming composition*2 (mass parts) | | | | | | | | | | | | | | | | Evaluation item | | |
| --- | --- | --- | --- | --- | --- | --- | --- | --- | --- | --- | --- | --- | --- | --- | --- | --- | --- | --- | --- |
| | Component (A) | | | | | Component (B) | | | | | Component (C1) | Component (C2) | | Component (D) | Component (E) | Total | Thermal conductivity (W/(m·K)) | Peeling strength of copper foil (N/10 mm) | Reliability (number of NG chips/25) |
| | A-1 | A-2 | A-3 | A-4 | A-5 | BPA328 | EPIKOTE 1055 | HP7200HH | DICY | 2PH-Z | UHP-2 | PT-620 | CB-20A | MA-600B | X-41-1056 | | | | |
| Example 1 | 19.0 | – | – | – | – | 11.4 | 1.9 | 5.7 | 0.46 | 0.46 | 19.6 | – | 39.2 | 1.9 | 0.38 | 100.0 | 3.0 | 7.0 | 0/25 |
| Example 2 | – | 19.0 | – | – | – | 11.4 | 1.9 | 5.7 | 0.46 | 0.46 | 19.6 | – | 39.2 | 1.9 | 0.38 | 100.0 | 3.0 | 2.3 | 0/25 |
| Example 3 | 19.0 | – | – | – | – | 11.4 | 1.9 | 5.7 | 0.46 | 0.46 | 9.8 | – | 49.0 | 1.9 | 0.38 | 100.0 | 2.3 | 9.5 | 0/25 |
| Comparative Example 1 | – | – | 19.0 | – | – | 11.4 | 1.9 | 5.7 | 0.46 | 0.46 | 19.6 | – | 39.2 | 1.9 | 0.38 | 100.0 | 3.0 | 2.0 | 25/25 |
| Comparative Example 2 | – | – | – | 19.0 | – | 11.4 | 1.9 | 5.7 | 0.46 | 0.46 | 19.6 | – | 39.2 | 1.9 | 0.38 | 100.0 | 3.0 | 1.3 | 25/25 |
| Comparative Example 3 | – | – | – | – | 19.0 | 11.4 | 1.9 | 5.7 | 0.46 | 0.46 | 19.6 | – | 39.2 | 1.9 | 0.38 | 100.0 | 1.8 | 3.0 | 1/25 |
| Comparative Example 4 | – | – | 19.0 | – | – | 11.4 | 1.9 | 5.7 | 0.46 | 0.46 | – | – | 58.8 | 1.9 | 0.38 | 100.0 | 1.1 | 10.6 | 0/25 |
| Comparative Example 5 | 19.0 | – | – | – | – | 11.4 | 1.9 | 5.7 | 0.46 | 0.46 | – | 58.8 | – | 1.9 | 0.38 | 100.0 | 1.3 | 2.6 | 25/25 |
| Comparative Example 6 | 19.0 | – | – | – | – | 11.4 | 1.9 | 5.7 | 0.46 | 0.46 | – | 19.6 | 39.2 | 1.9 | 0.38 | 100.0 | 1.0 | 6.0 | 25/25 |

*2: Effective component ratio

From Table 2, the cured protective film in which the protective film made of the composition of Examples 1 to 3 is cured has a high thermal conductivity and also has an excellent adhesion with copper foil. Moreover, it is found that the chip with the cured protective film comprising the cured protective film also has an excellent reliability.

On the other hand, the cured protective film that had all of the above-described properties was not able to be formed in Comparative Examples 1 to 6.

That is to say, in Comparative Example 1, since the Tg of the acryl copolymer contained in the composition was low and the content of the constitutional unit derived from a glycidyl group-containing monomer was large, the result was that the obtained chip with a cured protective film was inferior in reliability and the cured protective film that was formed was inferior also in adhesion with copper foil.

In addition, as in Comparative Example 4, by not blending the component (C1) in the composition, the reliability of the obtained chip with the cured protective film was more improved, however the cured protective film that was formed had a lowered thermal conductivity and was inferior in heat dissipation performance when compared with the reliability, the thermal conductivity, and the heat dissipation performance in Comparative Example 1.

Also in Comparative Example 2, since the content of the constitutional unit derived from a glycidyl group-containing monomer of the acryl copolymer contained in the composition was large, the result was that the obtained chip with the cured protective film was inferior in the reliability and the cured protective film that was formed was inferior also in adhesion with the copper foil.

Moreover, in Comparative Example 3, since the Tg of the acryl copolymer contained in the composition was low, the result was that the cured protective film that was formed had a lowered thermal conductivity and was inferior in the heat dissipation performance.

In Comparative Examples 5 and 6, since the component (C1) was not blended in the composition, the result was not only that the cured protective film that was formed had a lowered thermal conductivity and was inferior in the heat dissipation performance but also that the obtained chip with a cured protective film was also inferior in the reliability.

Industrial Applicability

The protective film-forming composition of the present invention is suitable for a protective film-forming material protecting the back surface of a semiconductor chip.

**Claims**

1. A composition for forming a protective film for protecting a surface of a chip, the composition comprising: an acrylic polymer (A); a curable component (B); and an inorganic filler (C), wherein

   a content of a constitutional unit derived from a glycidyl group-containing monomer relative to all the structural units constituting the acrylic polymer (A) is 0 to 8% by mass, and the acrylic polymer (A) has a glass transition temperature of -3°C or higher;

   **characterized in that**:

   J the acrylic polymer (A) comprises a constitutional unit (a1) derived from a (meth)acrylic acid alkyl ester and a constitutional unit (a2) derived from a monomer comprising a functional group other than the glycidyl group and a content of the constitutional unit (a1) derived from the (meth)acrylic acid alkyl ester comprising an alkyl group having 4 or more carbon atoms relative to all the structural units constituting the acrylic polymer (A) is 0 to 12% by mass; and the inorganic filler (C) comprises anisotropically shaped boron nitride particles (C1) having an aspect ratio 2 to 30 (C1) and further inorganic filler (C2) other than the anisotropically shaped boron nitride particles.

2. The composition according to claim 1, wherein a content of the boron nitride particles (C1) relative to the total amount of effective components contained in the composition is 3 to 40% by mass, wherein effective components are components of the composition excluding solvents of the components contained in the composition.

3. The composition according to claim 1 or 2, wherein an average particle diameter of the boron nitride particles (C1) is 10 to 30 μm and wherein the value of the average particle diameter is calculated as an arithmetic mean value of the major axis diameters measured for 20 particles randomly selected in a transmission electron micrograph photograph.

4. The composition according to any one of claims 1 to 3, wherein the further inorganic filler (C2) is a spherical inorganic filler having an average particle diameter of 10 to 40 μm.

5. The composition according to any one of claims 1 to 4, wherein the anisotropically shaped boron nitride particles (C1) have at least one shape selected from the group consisting of a plate shape, an acicular shape, and a scale-like shape, and wherein a mass ratio of the further inorganic filler (C2) to the boron nitride particles (C1) is 1/2 to 7/1.

6.  The composition according to any one of claims 1 to 5, further comprising a colorant (D).

7.  The composition according to any one of claims 1 to 6, further comprising a coupling agent (E).

8.  The composition according to any one of claims 1 to 7, having a content of the acrylic poylymer (A) of 5 to 50% by mass, a content of the curable component (B) of 5 to 50% by mass, and a content of the inorganic filler (C) of 20 to 90% by mass relative to the total amount of effective components contained in the composition, wherein effective components are components of the composition excluding solvents of the components contained in the composition.

9.  A protective sheet comprising a protective film made of the composition according to any one of claims 1 to 8.

10. The protective sheet according to claim 9, wherein protective film is cured and has a thermal conductivity of 1.0 W/(m·K) or more.

11. The protective sheet according to claim 9 or 10, wherein the protective film has a thickness of 10 to 70 μm.

12. A chip with a cured protective film, comprising a cured protective film on a surface of a chip, the cured protective film obtained by curing a protective film made of the composition according to any one of claims 1 to 8 or a cured protective sheet according to any one of claims 9 to 11.


**Patentansprüche**

1.  Zusammensetzung zur Bildung eines Schutzfilms zum Schutz einer Oberfläche eines Chips, wobei die Zusammensetzung umfasst: ein Acrylpolymer (A); eine härtbare Komponente (B); und einen anorganischen Füllstoff (C), wobei der Gehalt einer Struktureinheit, abgeleitet von einem Glycidylgruppen-enthaltenden Monomer, relativ zu allen Struktureinheiten, die das Acrylpolymer (A) bilden, 0 bis 8 Masse-% beträgt, und das Acrylpolymer (A) eine Glasübergangstemperatur von -3°C oder höher aufweist;
das Acrylpolymer (A) eine Struktureinheit (a1) umfasst, abgeleitet von einem (Meth)acrylsäurealkylester, und eine Struktureinheit (a2), abgeleitet von einem Monomer, umfassend eine andere funktionelle Gruppe als die Glycidylgruppe, und der Gehalt der Struktureinheit (a1), abgeleitet von dem (Meth)acrylsäurealkylester, umfassend eine Alkylgruppe mit 4 oder mehr Kohlenstoffatomen relativ zu allen Struktureinheiten, die das Acrylpolymer (A) bilden, 0 bis 12 Masse-% beträgt; und
der anorganische Füllstoff (C) ein anisotrop geformtes Bornitridteilchen (C1) mit einem Seitenverhältnis von 2 bis 30 (C1) und einen anderen anorganischen Füllstoff (C2) als das anisotrop geformte Bornitridteilchen umfasst.

2.  Die Zusammensetzung nach Anspruch 1, wobei ein Gehalt der Komponente (C1), bezogen auf die Gesamtmenge der effektiven Komponenten, enthalten in der schutzfilmbildenden Zusammensetzung, 3 bis 40 Massenprozent beträgt, wobei effektive Komponenten Komponenten sind, die Lösungsmittel aus den in der Zusammensetzung enthaltenen Komponenten ausschließen.

3.  Die Zusammensetzung nach Anspruch 1 oder 2, wobei ein durchschnittlicher Partikeldurchmesser der Komponente (C1) 10 bis 30 μm beträgt und wobei der Wert des durchschnittlichen Partikeldurchmessers ein zahlenmittlerer Partikeldurchmesser ist, der als arithmetischer Mittelwert der Hauptachsendurchmesser berechnet wird, die für 20 zufällig in einer Transmissionselektronenmikroskop-Aufnahme ausgewählte Partikel gemessen wurden.

4.  Die Zusammensetzung nach einem der Ansprüche 1 bis 3, wobei die Komponente (C2) ein sphärischer anorganischer Füllstoff mit einem durchschnittlichen Teilchendurchmesser von 10 bis 40 μm ist

5.  Die Zusammensetzung nach einem der Ansprüche 1 bis 4, wobei das anisotrop geformte Bornitridteilchen als Komponente (C1) mindestens eine Form aufweist, ausgewählt aus der Gruppe bestehend aus einer Plattenform, einer nadelförmigen Form und einer schuppenartigen Form, und wobei ein Massenverhältnis [(C2)/(C1)] der Komponente (C2) zur Komponente (C1) 1/2 bis 7/1 beträgt.

6.  Die Zusammensetzung nach einem der Ansprüche 1 bis 5, ferner umfassend ein Farbmittel (D).

**7.** Zusammensetzung nach einem der Ansprüche 1 bis 6, ferner enthaltend ein Kopplungsmittel (E).

**8.** Die Zusammensetzung nach einem der Ansprüche 1 bis 7, mit einem Gehalt an dem Acrylpolymer (A) von 5 bis 50 Massenprozent, einem Gehalt an der Komponente (B) von 5 bis 50 Massenprozent und einem Gehalt an dem anorganischen Füllstoff (C) von 20 bis 90 Massenprozent, bezogen auf die Gesamtmenge der in der effektiven Komponente, enthalten in der schutzfilmbildenden Zusammensetzung, wobei effektive Komponenten Komponenten sind, ausgenommen Lösungsmittel der in der Zusammensetzung enthaltenen Komponenten.

**9.** Eine schutzfilmbildende Folie, umfassend einen Schutzfilm, hergestellt aus der Zusammensetzung nach einem der Ansprüche 1 bis 8.

**10.** Die Folie nach Anspruch 9, wobei ein gehärteter Schutzfilm, erhalten durch Härten des Schutzfilms, eine Wärmeleitfähigkeit von 1,0 W/(m·K) oder mehr aufweist.

**11.** Die Folie nach Anspruch 9 oder 10, wobei die Schutzfolie eine Dicke von 10 bis 70 μm aufweist.

**12.** Ein Chip mit einem gehärteten Schutzfilm, umfassend einen gehärteten Schutzfilm auf einer Oberfläche eines Chips, wobei der gehärtete Schutzfilm durch Härten eines Schutzfilms aus der Zusammensetzung nach einem der Ansprüche 1 bis 8 oder eines Schutzfilms der schutzfilmbildenden Folie nach einem der Ansprüche 9 bis 11 erhalten wurde.

## Revendications

**1.** Composition destinée à former un film de protection pour protéger une surface d'une puce, la composition comprenant un polymère acrylique (A) ; un composant durcissable (B) ; et un agent de remplissage inorganique (C), dans laquelle une teneur en une unité constitutionnelle dérivée d'un monomère contenant un groupe glycidyle par rapport à toutes les unités constitutionnelles, qui constituent le polymère acrylique (A), est 0 à 8 % en masse, et le polymère acrylique (A) a une température de transition vitreuse de -3°C ou plus ; **caractérisée en ce que** :

le polymère acrylique (A) comprend une unité constitutionnelle (a1) dérivée d'un ester alkyle d'acide (méth)acrylique et une unité constitutionnelle (a2) dérivée d'un monomère comprenant un groupe fonctionnel différent du groupe glycidyle et une teneur en l'unité constitutionnelle (a1) dérivée de l'ester alkyle d'acide (méth)acrylique comprenant un groupe alkyle ayant 4 ou plus d'atomes de carbone par rapport à toutes les unités constitutionnelles, qui constituent le polymère acrylique (A), est 0 à 12 % en masse ; et
l'agent de remplissage inorganique (C) comprend des particules de nitrure de bore en forme anisotrope (C1) ayant un rapport d'aspect de 2 à 30 (C1) et un autre agent de remplissage (C2) différent des particules de nitrure de bore en forme anisotrope.

**2.** Composition selon la revendication 1, dans laquelle une teneur en particules de nitrure de bore (C1) par rapport à la quantité totale de composants efficaces contenus dans la composition est 3 à 40 % en masse, dans lequel des composants efficaces sont des composants de la composition à l'exclusion de solvants des composants contenus dans la composition.

**3.** Composition selon la revendication 1 ou la revendication 2, dans laquelle un diamètre de particule moyen des particules de nitrure de bore (C1) est compris entre 10 et 30 μm, et dans laquelle la valeur du diamètre de particule moyen est calculée comme une valeur arithmétique moyenne des diamètres d'axe principal mesurée pour 20 particules sélectionnées aléatoirement dans une photographie de micrographie électronique par transmission.

**4.** Composition selon l'une quelconque des revendications 1 à 3, dans laquelle l'autre agent de remplissage inorganique (C2) est un agent de remplissage inorganique sphérique ayant un diamètre de particule moyen compris entre 10 et 40 μm.

**5.** Composition selon l'une quelconque des revendications 1 à 4, dans laquelle les particules de nitrure de bore en forme anisotrope (C1) ont au moins une forme sélectionnée dans le groupe composé de forme de plaque, de forme aciculaire et de forme d'écaille, et dans laquelle un rapport de masse de l'autre agent de remplissage inorganique (C2) par rapport aux particules de nitrure de bore (C1) est 1/2 à 7/1.

**6.** Composition selon l'une quelconque des revendications 1 à 5, comprenant en outre un colorant (D).

**7.** Composition selon l'une quelconque des revendications 1 à 6, comprenant en outre un agent de couplage (E).

**8.** Composition selon l'une quelconque des revendications 1 à 7, comprenant une teneur en polymère acrylique (A) comprise entre 5 et 50 % en masse, une teneur en composant durcissable (B) comprise entre 5 et 55 % en masse et une teneur en agent de remplissage inorganique (C) comprise entrew 20 et 90 % en masse par rapport à la quantité totale de composants efficaces contenus dans la composition, dans lequel des composants efficaces sont des composants de la composition à l'exclusion de solvants des composants contenus dans la composition.

**9.** Feuille de protection comprenant un film de protection fabriqué à partir de la composition selon l'une quelconque des revendications 1 à 8.

**10.** Feuille de protection selon la revendication 9, dans laquelle le film de protection est durci et il comprend une conductivité thermique de 1,0 W/(m·k) ou plus.

**11.** Feuille de protection selon la revendication 9 ou la revendication 10, dans laquelle le film de protection a une épaisseur comprise entre 10 et 70 $\mu$m.

**12.** Puce avec un film de protection durci, comprenant un film de protection durci sur une surface d'une puce, le film de protection durci étant obtenu en durcissant un film de protection fabriqué à partir de la composition selon l'une quelconque des revendications 1 à 8, ou comprenant une feuille de protection durcie selon l'une quelconque des revendications 9 à 11.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002280329 A
- US 2008260982 A1
- JP H0516296 A
- US 2007026572 A